# EUROPÄISCHE PATENTSCHRIFT

(11) **EP 0 649 566 B1**
(45) Veröffentlichungstag und Bekanntmachung des Hinweises auf die Patenterteilung: **26.11.1997**
(21) Anmeldenummer: 93912589.4
(22) Anmeldetag: 15.06.1993
(51) Int. Cl.: H01L 27/108, H01L 21/8242, G11C 11/404

(54) **VERFAHREN ZUR HERSTELLUNG VON SPEICHERKONDENSATOREN FÜR DRAM-ZELLEN**
PROCESS FOR PRODUCING STORAGE CAPACITORS FOR DRAM CELLS
PROCEDE DE FABRICATION DE CONDENSATEURS DE MEMORISATION POUR CELLULES DRAM

(30) Priorität: 08.07.1992 DE 4222467
(43) Veröffentlichungstag der Anmeldung: 26.04.1995
(73) Patentinhaber: SIEMENS AKTIENGESELLSCHAFT, 80333 München (DE)
(72) Erfinder: RÖSNER, Wolfgang, D-81739 München (DE)
(86) Internationale Anmeldenummer: DE9300516
(87) Internationale Veröffentlichungsnummer: WO9401891

(56) Entgegenhaltungen:
- EP-A- 0 443 439
- DE-A- 4 102 184
- DE-A- 4 113 233
- 1989 SYMPOSIUM ON VLSI TECHNOLOGY, Nr. 89/IEEE CAT., 22-25 Mai 1989, pp. 69,70; K. WAKAMIYA et al.: 'Novel stacked capacitor cell for 64Mb DRAM'
- IEEE Transactions on Electron Devices, Vol. 38, Nr. 2, Februar 1991, New York, US, pp. 255-261; KAGA et al.: 'Crown-shaped stacked-capacitor cell for 1.5-V operation 64-Mb DRAM's'

## Beschreibung

Eine Stacked-Capacitor-DRAM-Zelle umfaßt einen MOS-Transistor und einen Speicherkondensator, wobei der MOS-Transistor in einem Siliziumsubstrat angeordnet ist und der Speicherkondensator aus zwei dotierten Polysiliziumschichten und einer dazwischen angeordneten dielekrischen Schicht besteht, die an der Oberfläche des Substrats angeordnet sind. Der Speicherkondensator überdeckt dabei ganz oder teilweise diejenige Fläche, die von dem Transistor belegt wird.

Um die Kapazität des Speicherkondensators bei gleicher Größe der belegten Oberfläche auf dem Substrat weiter zu vergrößern und damit den Flächenbedarf auf dem Substrat bei gleichbleibender Kapazität des Speicherkondensators zu verkleinern, ist vorgeschlagen worden, den Speicherkondensator zylindrisch auszubilden. Dazu wird der Speicherknoten, d. h. diejenige Elektrode des Speicherkondensators, auf der die Information in Form von Ladung gespeichert wird, zylindrisch ausgebildet. Sie umfaßt neben der Bodenfläche, die an der Oberfläche des Substrats angeordnet ist, eine in die Höhe ragende Mantelfläche. Die dielektrische Schicht ist an der Oberfläche der Bodenfläche und innen und außen an der Oberfläche der Mantelfläche angeordnet. Die Zellplatte, d. h. die zweite Elektrode des Speicherkondensators, ist dann auf der Oberfläche der dielektrischen Schicht angeordnet. Auf diese Weise läßt sich die Fläche des Kondensators gegenüber der auf dem Substrat beanspruchten Fläche drastisch vergrößern.

Zur Herstellung des Speicherkondensators wird an der Oberfläche des Substrats zunächst eine Hilfsschicht hergestellt. In dieser werden Öffnungen hergestellt. Zur Bildung der Speicherknoten wird eine dünne Schicht aus dotiertem Polysilizium auf der Hilfsschicht mit den Öffnungen abgeschieden. Der auf den Seitenwänden und dem Boden der Öffnungen abgeschiedene Teil der Polysiliziumschicht bildet den späteren Speicherknoten. Die Seitenwände der Öffnungen sollten daher möglichst senkrecht sein.

Nach Bildung der Speicherknoten durch Entfernen des Anteils der Polysiliziumschicht an der Oberfläche der Hilfsschicht und nach Entfernen der Hilfsschicht, wird ganzflächig ein Speicherdielektrikum aufgebracht. Dieses verläuft sowohl auf den Innen- als auch auf den Außenflächen des freistehenden Mantelteils des Speicherknotens. Anschließend wird die Zellplatte als Gegenelektrode ganzflächig aufgebracht.

Die Hilfsschicht wird auf die Oberfläche des Substrats aufgebracht, in der zuvor die MOS-Transistoren hergestellt wurden. Zwischen den Speicherknoten und dem jeweiligen aktiven Gebiet des zugeordneten Transistors muß ein Zellkontakt hergestellt werden. Dieser kann direkt oder über zusätzliche, elektrisch leitende Strukturen folgen. Vor der Abscheidung der Hilfsschicht ist die Oberfläche des Substrats in der Regel mit einer isolierenden Schicht bedeckt. Beim Herstellen der Öffnung in der Hilfsschicht muß sichergestellt werden, daß es nicht zu einer unkontrollierten Strukturierung der unter der Hilfsschicht liegenden isolierenden Schicht kommt. Entstehen bei der Herstellung der Öffnungen außer den Zellkontakten noch zu anderen leitfähigen Gebieten hin Löcher in der isolierenden Schicht, kommt es über diese zu Kurzschlüssen zu den anschließend gebildeten Speicherknoten. Dieses ist zu vermeiden.

Zur Lösung dieses Problems ist aus W. Wakamiya et al, Symp. on VLSI-Technology 1989, S. 69 bekannt, unter der Hilfsschicht, die aus SiO₂ gebildet wird, im Bereich der Speicherknoten eine Polysiliziumunterlage zu bilden. Diese wird vor Abscheidung der Hilfsschicht durch ganzflächige Abscheidung einer Polysiliziumschicht und anschließende Strukturierung unter Verwendung einer Fotolackmaske hergestellt. Die Größe der Polysiliziumunterlage wird so bemessen, daß die SiO₂-Ätzung zur Bildung der Öffnung in der Hilfsschicht sicher darauf trifft. Die Polysiliziumunterlage wirkt bei dieser Ätzung als Ätzstopp. Die Polysiliziumunterlage verbleibt in der Speicherzelle als Teil des späteren Speicherknotens.

Aus Y. Kawamoto et al, Symp. on VLSI-Technology 1990, S. 13 ist bekannt, die Hilfsschicht aus Polyimid zu bilden. Die Herstellung der Öffnungen in der Hilfsschicht ist dann unkritisch, da Polyimid mit guter Selektivität zu SiO₂ ätzbar ist. An der Oberfläche der Polyimidhilfsschicht wird nach Herstellung entsprechender Öffnungen eine Polysiliziumschicht abgeschieden zur Herstellung der Speicherknoten. Wegen der geringen Temperaturstabilität des Polyimid muß die Temperatur bei der Polysiliziumabscheidung begrenzt werden.

Aus T. Kaga et al, IEEE Trans. Electr. Dev., Bd. 38, 1991, S. 255 ist bekannt, als Hilfsschicht eine zusammengesetzte Schicht aus Si₃N₄ und SiO₂ zu verwenden. Die Öffnungen werden im SiO₂ und im Si₃N₄ gebildet. Zur Bildung der Öffnung im Si₃N₄ ist ein besonderer Plasmaätzprozeß erforderlich, der mit einer Selektivität von 40:1 relativ zu SiO₂ ätzt.

Aus DE-A-4 113 233 ist ein Verfahren zur Herstellung von Speicherkondensatoren für DRAM-Zellen bekannt.

Der Erfindung liegt das Problem zugrunde, ein weiteres Verfahren zur Herstellung von Speicherkondensatoren für DRAM-Zellen anzugeben, das zum Einsatz bei der Herstellung einer Stacked-Capacitor-DRAM-Zelle geeignet ist und in dem ein unkontrolliertes Freiätzen von elektrisch leitenden Strukturen im Substrat bei der Herstellung von Öffnungen in einer an der Oberfläche des Substrats angeordneten Hilfsschicht sicher vermieden wird.

Dieses Problem wird erfindungsgemäß gelöst durch ein Verfahren nach Anspruch 1.

Dabei wird auf einer ganzflächig mit SiO₂ versehenen Oberfläche eines Substrats ganzflächig eine erste Hilfsschicht aus Polysilizium abgeschieden. Im Substrat sind zuvor Transistoren und ggf. elektrische Verbindungselemente hergestellt. Die erste Hilfsschicht wird entsprechend der Anordnung der Speicherkondensatoren strukturiert, so daß sie Öffnungen aufweist, die jeweils zwischen Speicherknoten benachbarter Speicherkondensatoren verlaufen. Es wird ganzflächig eine zweite Hilfsschicht aus SiO₂ abgeschieden, wobei die Öffnungen in der ersten Hilfsschicht mit SiO₂ aufgefüllt werden. SiO₂ ist mit guter Selektivität zu Polysilizium ätzbar, so daß in einem selektiven Ätzprozeß die Oberfläche der ersten Hilfsschicht durch Rückätzen der zweiten Hilfsschicht freigelegt wird. In den Öffnungen verbleibt SiO₂ als Platzhalter. Die erste Hilfsschicht wird selektiv zu SiO₂ vollständig entfernt, so daß die Platzhalter stehen bleiben.

Durch die Prozeßführung vor der Abscheidung der ersten Hilfsschicht wird insbesondere bewerkstelligt, daß eine leitfähige Struktur zum Anschluß der Speicherknoten nur durch eine dünne SiO₂-Schicht bedeckt ist. Diese wird durch ein kurzes ganzflächiges Rückätzen von SiO₂ entfernt.

Durch ganzflächiges Abscheiden einer dotierten Polysiliziumschicht und Freilegen der Oberfläche der Platzhalter jeweils im oberen Bereich der Platzhalter werden die Speicherknoten gebildet. Auf diese Weise bedecken die Speicherknoten die Fläche innerhalb der Platzhalter vollständig und die Seitenwände der Platzhalter im wesentlichen. Auf diese Weise hergestellte Speicherknoten sind im wesentlichen zylinderförmig, wobei die Fläche innerhalb der Platzhalter die Bodenfläche, und der an den Seitenwände der Platzhalter angeordnete Anteil der Polysiliziumschicht die Mantelfläche eines Zylinders bilden. Nach Entfernen der Platzhalter selektiv zu den Speicherknoten werden ganzflächig Speicherdielektrikum und eine leitfähige Schicht als Zellplatte erzeugt.

Da die erste Hilfsschicht aus Polysilizium gebildet wird und unter der ersten Hilfsschicht SiO₂ durchgehend vorhanden ist und weil Polysilizium mit guter Selektivität zu SiO₂ ätzbar ist, braucht bei der Bildung der Öffnungen in der ersten Hilfsschicht ein unkontrolliertes Freilegen von elektrischen Strukturen unterhalb der SiO₂-Oberfläche nicht befürchtet zu werden.

Die Strukturierung der ersten Hilfsschicht erfolgt unter Verwendung einer Fotolackmaske. Alle weiteren Strukturierungen können selbstjustiert, d. h. ohne weitere Fotolackmaske erfolgen. Eine Fotolackmaske wäre zur Strukturierung der Speicherknoten ohnehin notwendig. In dem erfindungsgemäßen Verfahren wird die Einführung zusätzlicher Fotolackmasken vermieden.

Es liegt im Rahmen der Erfindung, zum Freilegen der Oberfläche im oberen Bereich des Platzhalters eine Fotolackschicht zu verwenden, die durch Rückbelichtung und Entwicklung nur im oberen Teil der mit der dotierten Polysiliziumschicht bedeckten Platzhalter entfernt wird.

Der Platzhalter wird z. B. durch eine SiO₂-Ätzung entfernt, bei der der Ätzabtrag über die Ätzdauer eingestellt wird.

Um eine genauere Endpunktkontrolle bei der Entfernung des Platzhalters zu haben, liegt es im Rahmen der Erfindung, unter dem Platzhalter einen Ätzstopp aus Si₃N₄ vorzusehen.

Dazu wird nach der Strukturierung der ersten Hilfsschicht vor der Abscheidung der zweiten Hilfsschicht eine Si₃N₄-Schicht abgeschieden, die dünner ist, als es der halben Weite der Öffnungen in der ersten Hilfsschicht entspricht. Bei der Rückätzung der zweiten Hilfsschicht wird die Oberfläche der Si₃N₄-Schicht im Bereich der ersten Hilfsschicht freigelegt. In einer Si₃N₄-Ätzung selektiv zu Polysilizium wird dann die Oberfläche der ersten Hilfsschicht freigelegt. Die Platzhalter sind in diesem Fall von dem sie in den Öffnungen umgebenden Anteil der Si₃N₄-Schicht umgeben. Nach der Bildung der Speicherknoten werden die Platzhalter durch eine zu Si₃N₄ selektive SiO₂-Ätzung entfernt. Anschließend wird eine Si₃N₄-Ätzung selektiv zu Polysilizium und SiO₂ durchgeführt, wobei die Reste der Si₃N₄-Schicht vollständig entfernt werden.

Weitere Ausgestaltungen der Erfindung gehen aus den übrigen Ansprüchen hervor.

Im folgenden wird die Erfindung anhand eines Ausführungsbeispiels und der Figuren näher erläutert.
- Fig. 1: zeigt einen Schnitt durch ein Substrat, dessen Oberfläche ganzflächig mit SiO₂ versehen ist.
- Fig. 2: zeigt das Substrat nach Abscheidung einer ersten Hilfsschicht.
- Fig. 3: zeigt das Substrat nach Abscheidung einer zweiten Hilfsschicht.
- Fig. 4: zeigt das Substrat nach Bildung von Platzhaltern.
- Fig. 5: zeigt das Substrat nach Abscheidung einer dotierten Polysiliziumschicht.
- Fig. 6: zeigt das Substrat nach Bildung von Speicherknoten.
- Fig. 7: zeigt das Substrat mit nach dem erfindungsgemäßen Herstellverfahren gebildeten Speicherkondensatoren.

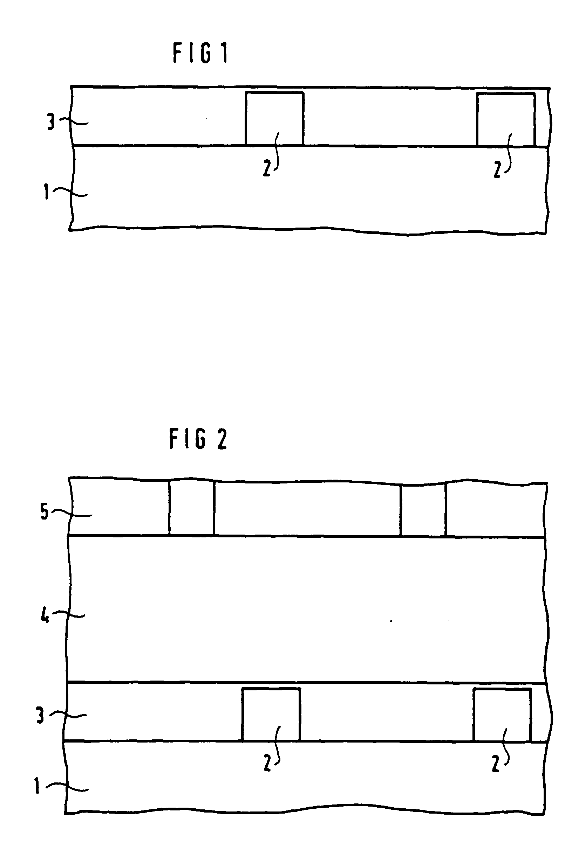

Das erfindungsgemäße Verfahren geht aus von einem Substrat 1 (s. Fig. 1), in dem zuvor Transistoren für eine DRAM-Zellenanordnung hergestellt wurden. Der Übersichtlichkeit halber sind diese Transistoren in Fig. 1 nicht im einzelnen dargestellt. Das Substrat 1 umfaßt elektrisch leitende Strukturen 2, über die die Transistoren mit nach dem erfindungsgemäßen Verfahren herzustellenden Speicherkondensatoren elektrisch verbunden werden. An der Oberfläche des Substrats 1 ist eine isolierende Schicht 3 vorgesehen, die die elektrisch leitenden Strukturen 2 sowie andere elektrisch leitende Komponenten, die nicht dargestellt sind, vollständig bedeckt. Die isolierende Schicht 3 besteht im wesentlichen aus SiO₂.

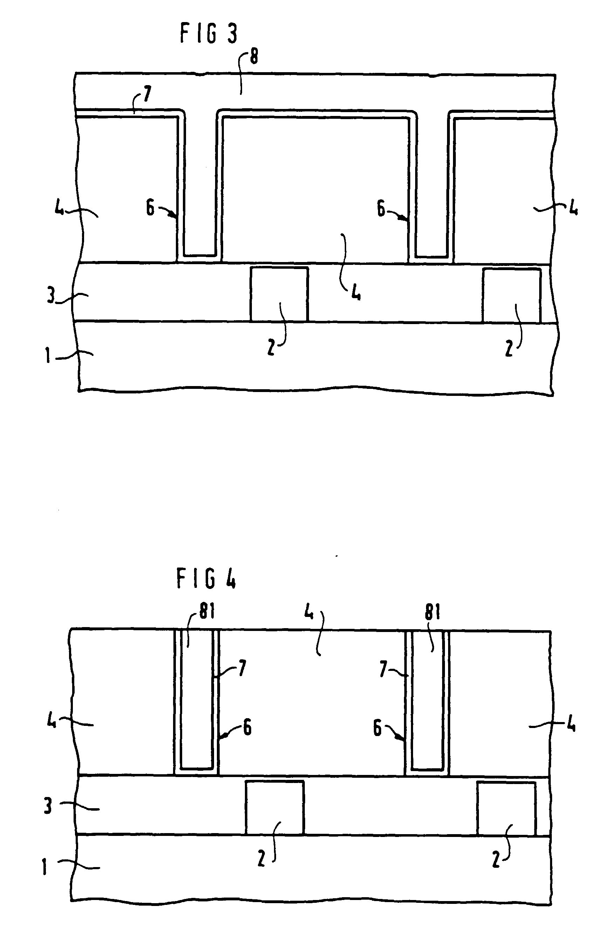

Auf die isolierende Schicht 3 (s. Fig. 2) wird ganzflächig eine erste Hilfsschicht 4 aufgebracht. Die erste Hilfsschicht 4 wird aus Polysilizium z. B. durch CVD-Abscheidung aufgebracht. Die erste Hilfsschicht 4 wird in einer Dicke von z. B. 1 µm aufgebracht. Die Dicke der ersten Hilfsschicht 4 bestimmt die Höhe der zylindrischen Seitenflächen der später herzustellenden Speicherknoten. Auf der ersten Hilfsschicht 4 wird eine Fotolackmaske 5 aufgebracht. Die Fotolackmaske 5 wird durch Abscheiden einer Fotolackschicht, Belichten und Entwickeln der Fotolackschicht erzeugt. In einem Trockenätzschritt z. B. mit HBr, Cl₂, C₂F₆ wird die erste Hilfsschicht 4 unter Verwendung der Fotolackmaske 5 als Ätzmaske strukturiert (s. Fig. 2 und 3). Dabei werden in der ersten Hilfsschicht 4 Öffnungen 6 gebildet. Die Öffnungen 6 verlaufen jeweils zwischen Orten, an denen später Speicherknoten benachbarter Speicherkondensatoren hergestellt werden. Die verbleibende erste Hilfsschicht 4 bedeckt diejenigen Bereiche der Oberfläche der isolierenden Schicht 3, die später von Speicherknoten bedeckt sind.

Nachfolgend wird eine Si₃N₄-Schicht 7 ganzflächig in einer Dicke von z. B. 20 nm abgeschieden. Auf die Si₃N₄-Schicht 7 wird ganzflächig eine zweite Hilfsschicht 8 abgeschieden. Die zweite Hilfsschicht 8 wird aus SiO₂ gebildet. Die zweite Hilfsschicht 8 wird in einer solchen Dicke abgeschieden, daß die Öffnungen 6 vollständig mit SiO₂ aufgefüllt sind. Die Dicke beträgt z. B. 200 nm. Die Abscheidung der zweiten Hilfsschicht 8 erfolgt z. B. konform.

In einem Trocken-Ätzschritt Ätzschritt mit z. B. CHF₃/O₂ wird die zweite Hilfsschicht 8 außerhalb der Öffnungen 6 entfernt. Dabei wird zunächst die Oberfläche der Si₃N₄-Schicht 7 freigelegt. In demselben Ätzschritt wird die Si₃N₄-Schicht 7 von waagerechten Oberflächen der ersten Hilfsschicht 4 aus Polysilizium entfernt. Die Ätzungen erfolgen jeweils selektiv zu Polysilizium. Die Öffnungen 6 bleiben mit einem Platzhalter 81 aus SiO₂, der der verbleibende Rest der zweiten Hilfsschicht 8 ist, gefüllt. Zwischen dem Platzhalter 81 und der umgebenden ersten Hilfsschicht 4 bzw. der darunterliegenden isolierenden Schicht 3 bleibt Si₃N₄ der Si₃N₄-Schicht 7 angeordnet (s. Fig. 4).

Anschließend wird die erste Hilfsschicht 4 durch naßchemisches Ätzen mit z. B. Cholin entfernt. Dieser Ätzschritt erfolgt selektiv zu SiO₂ und Si₃N₄. Da unter der ersten Hilfsschicht 4 ganzflächig die isolierende Schicht 3 aus SiO₂ angeordnet ist, ist bei dem Entfernen der ersten Hilfsschicht 4 sichergestellt, daß keine unkontrollierten Ätzungen in die isolierende Schicht 3 hinein erfolgen. Das SiO₂ wirkt bei der naßchemischen Ätzung als Ätzstopp.

Nachfolgend wird in einem Trockenätzprozeß die isolierende Schicht 3 oberhalb der elektrisch leitenden Strukturen 2 entfernt, um einen Kontakt zu den elektrisch leitenden Strukturen 2 zu öffnen. Durch die Vorprozessierung muß gewährleistet sein, daß dieser Trockenätzprozeß in SiO₂ keine ungewünschten Kurzschlüsse erzeugen kann. Dieses erfolgt insbesondere durch Einstellung der Schichtdicke der isolierenden Schicht 3.

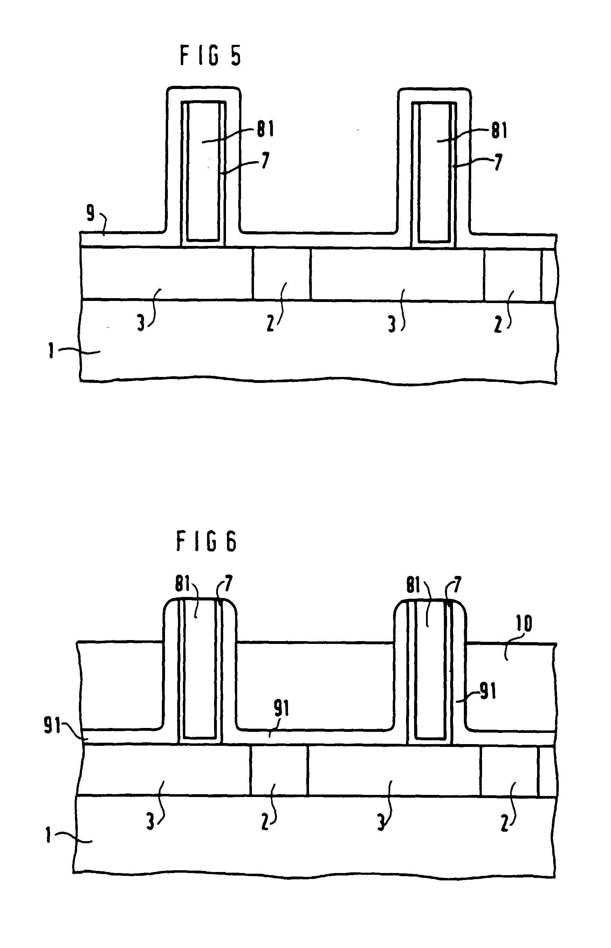

Es wird ganzflächig eine dotierte Polysiliziumschicht 9 abgeschieden in einer Dicke von z. B. 100 nm. Die dotierte Polysiliziumschicht 9 wird im wesentlichen konform abgeschieden und bedeckt den Platzhalter 81 vollständig (s. Fig. 5).

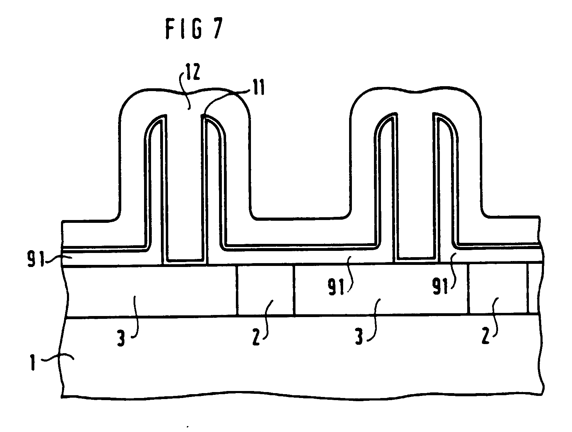

Nachfolgend wird ganzflächig eine Fotolackschicht abgeschieden, die die dotierte Polysiliziumschicht 9 vollständig bedeckt. Die Fotolackschicht wird rückbelichtet und entwickelt. Beim Rückbelichten wird die Fotolackschicht nur bis in eine vorgebbare Tiefe belichtet, so daß beim Entwickeln nur der obere Teil der Fotolackschicht entfernt wird. Die Fotolackschicht wird soweit belichtet, daß eine entwickelte Fotolackschicht 10 entsteht, die den oberen Teil der mit der dotierten Polysiliziumschicht 9 bedeckten Platzhalter 81 unbedeckt läßt (s. Fig. 6). Anschließend wird in einem anisotropen Trockenätzprozeß die dotierte Polysiliziumschicht 9 so strukturiert, daß die waagerechte Oberfläche des Platzhalters 81 und des umgebenden Si₃N₄ der Si₃N₄-Schicht 7 freigelegt wird. Dabei entstehen Speicherknoten 91.

Nach Entfernen der entwickelten Fotolackschicht 10 werden in einem Ätzschritt mit NH₄F, HF (5:1) die Platzhalter 81 selektiv zu Si₃N₄ und Polysilizium entfernt. Dabei wirkt das Si₃N₄ als Ätzstopp. In einem naßchemischen Ätzprozeß mit heißer HNO₃ wird anschließend der verbleibende Teil der Si₃N₄-Schicht 7 vollständig entfernt. Bei der Entfernung der Platzhalter 81 wirkt das Si₃N₄ als Ätzstopp. In Anwendungen, in denen es nicht auf eine präzise Einstellung der Tiefe, bis in die der Platzhalter 81 entfernt wird, ankommt, kann auf die Si₃N₄-Schicht 7 verzichtet werden. Dieses führt zu einer Prozeßvereinfachung.

Es wird ganzflächig ein Speicherdielektrikum z. B. durch Herstellung von thermischen SiO₂, Si₃N₄ und thermischen SiO₂ hergestellt. Auf dem Speicherdielektrikum 11 wird ganzflächig eine Zellplatte 12 aus dotiertem Polysilizium hergestellt.

Die Ausdehnung der einzelnen Speicherkondensatoren wird durch die Geometrie der Speicherknoten 91 festgelegt (s. Fig. 7). Dabei umfaßt der Speicherkondensator neben der Oberfläche der Bodenfläche des Speicherknotens 91 die Oberfläche der Innen- und Außenseite des zylindrischen Teils der Speicherknoten 91. Über die elektrisch leitenden Strukturen 2 sind die Speicherknoten mit den entsprechenden Transistoren verbunden.

Der Übersichtlichkeit halber wurde die Erfindung anhand eines Ausführungsbeispiels erläutert, in dem die isolierende Schicht 3 eine ebene Oberfläche aufweist. Das erfindungsgemäße Verfahren ist analog anwendbar, wenn die isolierende Schicht mit einer Oberflächentopologie versehen ist.

## Patentansprüche

1. Verfahren zur Herstellung von Speicherkondensatoren für DRAM-Zellen,
- bei dem auf einer ganzflächig mit SiO₂ (3) versehenen Oberfläche eines Substrats (1) ganzflächig eine erste Hilfsschicht (4) aus Polysilizium abgeschieden wird,
- bei dem die erste Hilfsschicht (4) entsprechend der Anordnung der Speicherkondensatoren strukturiert wird, so daß sie Öffnungen (6) aufweist, die jeweils zwischen Speicherknoten (91) benachbarter Speicherkondensatoren verlaufen,
- bei dem eine zweite Hilfsschicht (8) aus SiO₂ ganzflächig abgeschieden wird, wobei die Öffnungen (6) in der ersten Hilfsschicht (4) mit SiO₂ aufgefüllt werden,
- bei dem die zweite Hilfsschicht (8) selektiv zur ersten Hilfsschicht (4) rückgeätzt wird, so daß die Oberfläche der ersten Hilfsschicht (4) freigelegt wird und in den Öffnungen (6) Platzhalter (81) aus SiO₂ verbleiben,
- bei dem die erste Hilfsschicht (4) selektiv zu SiO₂ vollständig entfernt wird,
- bei dem ganzflächig eine dotierte Polysiliziumschicht (9) abgeschieden wird, die zur Bildung von Speicherknoten (91) so strukturiert wird, daß die Fläche innerhalb der Platzhalter (81) und die Seitenwände der Platzhalter (81) mit den Speicherknoten (91) bedeckt sind und die Oberfläche der Platzhalter (81) jeweils im oberen Bereich der Platzhalter (81) freigelegt ist,
- bei dem der Platzhalter (81) selektiv zu den Speicherknoten (91) im wesentlichen entfernt wird,
- bei dem ganzflächig ein Speicherdielektrikum (11) und eine leitfähige Schicht als Zellplatte (12) erzeugt werden.

2. Verfahren nach Anspruch 1,
bei dem vor der Abscheidung der dotierten Polysiliziumschicht (9) zur Bildung der Speicherknoten (91) in dem SiO₂ (3) an der Oberfläche des Substrats (1) Kontaktlöcher geöffnet werden, über die die Speicherknoten (91) mit in dem SiO₂ (3) an der Oberfläche des Substrats (1) angeordneten elekrisch leitenden Strukturen (2) elektrisch verbunden werden.

3. Verfahren nach Anspruch 1 oder 2,
- bei dem nach Abscheidung der dotieren Polysiliziumschicht (9) zur Bildung der Speicherknoten (91) eine Fotolackschicht aufgebracht wird, die die dotierte Polysiliziumschicht (9) vollständig bedeckt,
- bei dem die Fotolackschicht rückbelichtet und entwickelt wird, so daß nur der obere Teil der mit der dotierten Polysiliziumschicht (9) bedeckten Platzhalter (81) freigelegt wird,
- bei dem in einem anisotropen Trockenätzprozeß die dotierte Polysiliziumschicht (9) selektiv zu SiO₂ strukturiert wird, wobei die waagerechten Flächen der Platzhalter (81) freigelegt werden.

4. Verfahren nach einem der Ansprüche 1 bis 3,
- bei dem nach der Strukturierung der ersten Hilfsschicht (4) vor der Abscheidung der zweiten Hilfsschicht (8) eine Si₃N₄-Schicht (7) abgeschieden wird, die dünner ist als es der halben Weite der Öffnungen (6) in der ersten Hilfsschicht (4) entspricht,
- bei dem bei der Rückätzung der zweiten Hilfsschicht (8) die Oberfläche der Si₃N₄-Schicht im Bereich der ersten Hilfsschicht (4) freigelegt wird,
- bei dem eine Si₃N₄-Ätzung selektiv zu Polysilizium durchgeführt wird, wobei die Oberfläche der ersten Hilfsschicht (4) freigelegt wird,
- bei dem nach der Bildung der Speicherknoten (91) die Platzhalter (81) durch eine zu Si₃N₄ selektive SiO₂-Ätzung entfernt werden,
- bei dem anschließend eine Si₃N₄-Ätzung selektiv zum Polysilizium und SiO₂ durchgeführt wird, wobei die Reste der Si₃N₄-Schicht (7) entfernt werden.

5. Verfahren nach einem der Ansprüche 1 bis 4,
bei dem die Strukturierung der ersten Hilfsschicht (4) unter Verwendung einer Fotolackmaske (5) in einem Trockenätzprozeß erfolgt.

6. Verfahren nach einem der Ansprüche 1 bis 5,
bei dem die zweite Hilfsschicht (8) durch konforme Abscheidung gebildet wird.

7. Verfahren nach einem der Ansprüche 1 bis 6,
bei dem das Speicherdielektrikum (11) als Mehrfachschicht aus thermischen SiO₂, Si₃N₄ und thermischen SiO₂ gebildet wird.

8. Verfahren nach einem der Ansprüche 1 bis 7,
bei dem die Zellplatte (12) aus dotiertem Polysilizium gebildet wird.

9. Verfahren nach einem der Ansprüche 1 bis 8,
bei dem vor der Abscheidung der ersten Hilfsschicht (4) im Substrat Transistoren mit Bitleitungen und Wortleitungen für Stacked-Capacitor-DRAM-Zellen hergestellt werden.

## Claims

1. Process for producing storage capacitors for DRAM cells,
- in which a first auxiliary layer (4) of polysilicon is deposited over the entire surface of a substrate (1) provided over the entire surface with SiO₂ (3),
- in which the first auxiliary layer (4) is structured in accordance with the arrangement of the storage capacitors, so that it has openings (6) which extend in each case between storage nodes (91) of adjacent storage capacitors,
- in which a second auxiliary layer (8) of SiO₂ is deposited over the entire surface, in which process the openings (6) in the first auxiliary layer (4) are filled with SiO₂,
- in which the second auxiliary layer (8) is back-etched selectively with respect to the first auxiliary layer (4), so that the surface of the first auxiliary layer (4) is exposed and dummies (81) of SiO₂ are left behind in the openings (6),
- in which the first auxiliary layer (4) is completely removed selectively with respect to SiO₂,
- in which a doped polysilicon layer (9) is deposited over the entire surface and is structured to form storage nodes (91) in such a way that the area inside the dummies (81) and the side walls of the dummies (81) are covered with the storage nodes (91) and the surface of the dummies (81) is in each case exposed in the upper region of the dummies (81),
- in which the dummy (81) is essentially removed selectively with respect to the storage nodes (91),
- in which a storage dielectric (11) is produced over the entire surface and a conductive layer is produced as cell plate (12).

2. Process according to Claim 1, in which, prior to the deposition of the doped polysilicon layer (9) for forming the storage nodes (91), there are opened in the SiO₂ (3) at the surface of the substrate (1) contact holes via which the storage nodes (91) are electrically connected to electrically conducting structures (2) disposed in the SiO₂ (3) at the surface of the substrate (1).

3. Process according to Claim 1 or 2,
- in which, after deposition of the doped polysilicon layer (9) for forming the storage nodes (91), a photoresist layer is deposited which completely covers the doped polysilicon layer (9),
- in which the photoresist layer is back-exposed and developed, so that only the upper part of the dummies (81) covered with the doped polysilicon layer (9) is exposed, and
- in which, in an anisotropic dry etching process, the doped polysilicon layer (9) is structured selectively with respect to SiO₂, in which process the horizontal areas of the dummies (81) are exposed.

4. Process according to one of Claims 1 to 3,
- in which, after structuring the first auxiliary layer (4) prior to the deposition of the second auxiliary layer (8), an Si₃N₄ layer (7) is deposited which is thinner than half the width of the openings (6) in the first auxiliary layer (4),
- in which, during the back-etching of the second auxiliary layer (8), the surface of the Si₃N₄ layer is exposed in the region of the first auxiliary layer (4),
- in which an Si₃N₄ etching process is carried out selectively with respect to polysilicon, in which process the surface of the first auxiliary layer (4) is exposed,
- in which, after forming the storage nodes (91), the dummies (81) are removed by an SiO₂ etching process which is selective with respect to Si₃N₄, and
- in which an Si₃N₄ etching process is then carried out selectively with respect to polysilicon and SiO₂, in which process the remnants of the Si₃N₄ layer (7) are removed.

5. Process according to one of Claims 1 to 4, in which the first auxiliary layer (4) is structured using a photoresist mask (5) in a dry etching process.

6. Process according to one of Claims 1 to 5, in which the second auxiliary layer (8) is formed by conformal deposition.

7. Process according to one of Claims 1 to 6, in which the storage dielectric (11) is formed as a multilayer of thermal SiO₂, Si₃N₄ and thermal SiO₂.

8. Process according to one of Claims 1 to 7, in which the cell plate (12) is formed from doped polysilicon.

9. Process according to one of Claims 1 to 8, in which, prior to the deposition of the first auxiliary layer (4), transistors with bit lines and word lines for stacked-capacitor DRAM cells are produced in the substrate.

## Revendications

1. Procédé de production de condensateur de mémorisation pour cellules DRAM,
- dans lequel une première couche auxiliaire (4) de polysilicium est déposée sur toute la surface d'un substrat (1) pourvu sur toute la surface de SiO₂ (3),
- dans lequel la première couche auxiliaire (4) est structurée suivant la disposition des condensateurs de mémorisation, si bien qu'il comporte des ouvertures (6), qui passent respectivement entre des noeuds de mémorisation (91) de condensateurs de mémorisation voisins,
- dans lequel une seconde couche auxiliaire (8) en SiO₂ est déposée sur toute la surface, les ouvertures (6) dans la première couche auxiliaire (4) étant remplies de SiO₂,
- dans lequel la seconde couche auxiliaire (8) est gravée en retrait sélectivement par rapport à la première couche auxiliaire (4), si bien que la surface de la première couche auxiliaire (4) est dégagée et que des éléments auxiliaires (81) en SiO₂ restent dans les ouvertures (6),
- dans lequel la première couche auxiliaire (4) est éliminée en totalité sélectivement par rapport au SiO₂,
- dans lequel une couche de polysilicum dopée (9) est déposée sur toute la surface, qui est structurée pour la formation de noeuds de mémorisation (91) de telle sorte que la surface à l'intérieur des éléments auxiliaires (81) et les parois latérales des éléments auxiliaires (81) sont recouvertes par les noeuds de mémorisation (91) et la surface des éléments auxiliaires (81) est dégagée respectivement dans la zone supérieure des éléments auxiliaires (81),
- dans lequel l'élément auxiliaire (81) est éliminé substantiellement sélectivement par rapport aux noeuds de mémorisation (91),
- dans lequel un diélectrique de mémorisation (11) et une couche conductrice sont générés sur toute la surface comme platine à cellules (12).

2. Procédé selon la revendication 1,
dans lequel avant le dépôt de la couche de polysilicum (9) des trous de contact sont aménagés pour la formation des noeuds de mémorisation (91) dans le SiO₂ (3) à la surface du substrat (1), par l'intermédiaire desquels les noeuds de mémorisation (91) sont connectés électriquement aux structures (2) électroconductrices disposées dans le SiO₂ (3) à la surface du substrat (1).

3. Procédé selon la revendication 1 ou 2,
- dans lequel après le dépôt de la couche de polysilicum dopée (9), une couche de laque photosensible qui recouvre en totalité la couche de polysilicium dopée (9) est déposée pour la formation des noeuds de mémorisation (91),
- dans lequel la couche de laque photosensible est exposée et développée de telle sorte que seule la partie supéreure des éléments auxiliaires (81) recouverte de la couche de polysilicum dopée (9) est dégagée.
- dans lequel la couche de polysilicium dopée(9) est structurée sélectivement par rapport au SiO₂ dans un processus de gravure à sec anisotrope, les surfaces horizontales des éléments auxiliaires (81) étant dégagées.

4. Procédé selon l'une des revendications 1 à 3,
- dans lequel après la structuration de la première couche auxiliaire (4) avant le dépôt de la seconde couche auxiliaire (8) une couche de Si₃N₄ (7) plus mince que la moitié de la largeur des ouvertures (6) pratiquées dans la première couche auxiliaire (4), est déposée,
- dans lequel lors de la gravure en retrait de la seconde couche auxiliaire (8) la surface de la couche de Si₃N₄ est dégagée dans la zone de la première couche auxiliaire (4),
- dans lequel une gravure du Si₃N₄ est effectuée sélectivement par rapport au polysilicium, la surface de la première couche auxiliaire (4) étant dégagée,
- dans lequel après la formation des noeuds de mémorisation (91), les éléments auxiliaires (81) sont éliminés par une gravure du SiO₂ sélective par rapport au Si₃N₄,
- dans lequel une gravure du Si₃N₄ est ensuite effectuée sélectivement par rapport au polysilicium et au SiO₂, les restes de la couche de Si₃N₄ (7) étant éliminés.

5. Procédé selon l'une des revendications 1 à 4,
dans lequel la structuration de la première couche auxiliaire (4) s'effectue moyennant l'utilisation d'un masque de laque photosensible (5) dans un procédé de gravure à sec.

6. Procédé selon l'une des revendications 1 à 5,
dans lequel la seconde couche auxiliaire (8) est formée par dépôt conforme.

7. Procédé selon l'une des revendications 1 à 6,
dans lequel le diélectrique de mémorisation (11) est formé comme couche multiple constituée de SiO₂, Si₃N₄ thermique et de SiO₂ thermique.

8. Procédé selon l'une des revendications 1 à 7,
dans lequel la platine à cellules (12) est formée à partir de polysilicium dopé.

9. Procédé selon l'une des revendications 1 à 8,
dans lequel des transistors à lignes de bits et à lignes de mots pour cellules DRAM à condensateur superposé sont produits avant le dépôt de la première couche auxiliaire (4) dans le substrat.
